# EUROPÄISCHE PATENTSCHRIFT

(11) **EP 2 580 843 B1**
(45) Veröffentlichungstag und Bekanntmachung des Hinweises auf die Patenterteilung: **10.05.2017**
(21) Anmeldenummer: 11715911.1
(22) Anmeldetag: 15.04.2011
(51) Int. Cl.: H02J 7/35, H01L 31/042, G05F 1/46, H01L 31/02

(54) **VERFAHREN UND VORRICHTUNG ZUR STEUERUNG EINER ELEKTRISCHEN STROMERZEUGUNG EINES SUBMODULS IN EINER PHOTOVOLTAIKANLAGE**
METHOD AND DEVICE FOR CONTROLLING THE ELECTRICITY GENERATION OF A SUB-MODULE IN A PHOTOVOLTAIC SYSTEM
PROCÉDÉ ET DISPOSITIF POUR COMMANDER UNE GÉNÉRATION DE COURANT ÉLECTRIQUE DANS UN SOUS-MODULE D'UNE INSTALLATION PHOTOVOLTAÏQUE.

(30) Priorität: 08.06.2010 DE 102010029813
(43) Veröffentlichungstag der Anmeldung: 17.04.2013
(73) Patentinhaber: SMA Solar Technology AG, 34266 Niestetal (DE)
(72) Erfinder: MILDENSTEIN, Tobias, 97922 Lauda (DE); FUNK, Karsten, 99425 Weimar (DE)
(74) Vertreter: Lahnor, Peter
(86) Internationale Anmeldenummer: PCT/EP2011/055983
(87) Internationale Veröffentlichungsnummer: WO 2011/154185

(56) Entgegenhaltungen:
- US-A1- 2010 089 431
- ROBERTO GIRAL ET AL: "Minimizing the effects of shadowing in a PV module by means of active voltage sharing", INDUSTRIAL TECHNOLOGY (ICIT), 2010 IEEE INTERNATIONAL CONFERENCE ON, IEEE, PISCATAWAY, NJ, USA, 14. März 2010 (2010-03-14), Seiten 943-948, XP031681011, ISBN: 978-1-4244-5695-6

## Beschreibung

Die Erfindung betrifft ein Verfahren zur Steuerung einer elektrischen Stromerzeugung eines Submoduls in einer Photovoltaikanlage nach dem Oberbegriff des Anspruchs 1 und eine derartige Vorrichtung nach Anspruch 6.

### Stand der Technik

Aus dem Stand der Technik bekannte Solarmodule bestehen aus einer Vielzahl einzelner Solarzellen, die wiederum zu einer Reihe von Submodulen zusammengefasst sind. Diese Submodule werden vielfach auch als Substrings bezeichnet. Sie stellen funktionell die kleinste energieerzeugende Einheit des Solarmoduls dar. Zur Verschaltung der Substrings wird üblicherweise auf eine Anschlussdose zurückgegriffen. Dieses Bauteil stellt die Verbindung der innerhalb der Substrings verbundenen Solarzellen sowohl untereinander als auch zu den anderen Modulen und/oder zu einem Wechselrichter her. Die Anschlussdose enthält üblicherweise eine zwischen die metallischen Verbinder der Substrings eingefügte Schaltung aus so genannten Bypass-Dioden. Diese Bypass-Dioden überbrücken den Substring in dem Fall, in dem der im gesamten Solarmodul erzeugte Solarstrom höher als der im jeweiligen Substring erzeugte Solarstrom ist. Dieser Fall tritt üblicherweise immer dann ein, wenn der Substring verschattet wird, wie dies beispielsweise durch abgelagerten Schmutz, herangewehte Blätter oder tageszeitabhängige Schatten benachbarter Objekte, insbesondere von Schornsteinen, der Fall ist. Im Verschattungsfall wird die dem jeweiligen Substring zugeordnete Bypass-Diode leitfähig, wodurch der Substring überbrückt wird daher nicht mehr zur Stromerzeugung beiträgt. Dadurch wird einer Stromlimitierung durch die verschatteten Zellen vorgebeugt, allerdings bleibt die im Substring minimal erzeugte Solarenergie dadurch ungenutzt, das Solarmodul bringt damit insgesamt nicht die Leistung, die eigentlich erzeugt werden könnte.

Ein standesgemäßes Verfahren und eine entsprechende Vorrichtung sind aus der Druckschrift US 2010/089431 A1 bekannt.

### Offenbarung der Erfindung

Erfindungsgemäß ist ein Verfahren und eine Vorrichtung zur Steuerung der elektrischen Stromerzeugung in einer Photovoltaikanlage mit mindestens einem in die Photovoltaikanlage geschalteten Submodul vorgesehen.

Das erfindungsgemäße Verfahren zeichnet sich durch folgende Schritte aus:

Es wird ein in einem Umschaltzeittakt erfolgendes alternierendes Schalten des Submoduls zwischen einem on-Schaltzustand und einem bypass-Schaltzustand ausgeführt. Dabei ist das Submodul in dem on-Schaltzustand in die Photovoltaikanlage geschaltet und trägt zur Solarstromerzeugung bei, während es in dem bypass-Schaltzustand überbrückt ist.

Während des bypass-Schaltzustandes wird eine Gesamtstromstärke der Photovoltaikanlage gemessen und als ein Sollwert zwischengespeichert. Während des on-Schaltzustandes wird eine Submodulstromstärke gemessen und mit dem Sollwert verglichen. Bei einem Absinken der Submodulstromstärke unter den Sollwert wird ein von dem Umschaltzeittakt unabhängig erfolgendes Zurücksetzen des Submoduls in den bypass-Schaltzustand ausgeführt.

Der Verfahrensablauf zeichnet sich demnach durch zwei Umschaltprozesse aus. Während des ersten Umschaltprozesses, der mit einem zunächst festen Umschaltzeittakt ausgeführt wird, wird das Submodul in zeitlich zunächst festen Intervallen alternierend in einen ersten Schaltzustand versetzt, bei dem es in die Photovoltaikanlage geschaltet ist. In einem im festen Umschaltzeittakt folgenden zweiten Schaltzustand ist das Submodul überbrückt und dadurch aus dem Verband der Photovoltaikanlage schaltungstechnisch abgetrennt. Während des Zeitintervalls der Überbrückung wird eine im Gesamtsystem für unverschattete Solarmodule mögliche Stromstärke gemessen. Diese Stromstärke dient als ein Sollwert, der zwischengespeichert wird. Nach einem Umschalten in den on-Schaltzustand wird dann die durch das Submodul gelieferte Stromstärke als Submodulstromstärke gemessen und mit dem vorher ermittelten Sollwert verglichen.

Dieser erste Umschaltprozess generiert somit eine Abfrage- und Vergleichsprozedur, bei der zum einen die Stromstärke des Gesamtsystems insgesamt und zum anderen die Stromstärke des Submoduls gemessen und beide Werte fortlaufend alternierend miteinander verglichen werden. Es ist klar, dass das Zeitintervall für den bypass-Schaltzustand klein im Vergleich zu dem Zeitintervall sein kann, in dem sich das Submodul im on-Schaltzustand befindet.

Zusätzlich tritt zu dem ersten Umschaltprozess ein zweiter Umschaltprozess. Dieser wird als ein Zurücksetzen des Submoduls bezeichnet. Bei diesem wird das Submodul immer dann in den bypass-Schaltzustand versetzt, wenn die Stromstärke des Submoduls unter den Wert des Sollwertes sinkt. Dadurch wird das vorübergehend leistungsvermindert arbeitende Submodul schaltungstechnisch aus dem Verband der Photovoltaikanlage gelöst. Während der Ausführung des zweiten Umschaltprozesses läuft jedoch der erste Umschaltprozess weiter. Das bedeutet, dass zum einen fortlaufend neue Sollwerte ermittelt werden und dass zum anderen der zweite Umschaltprozess spätestens dann wieder aufgehoben wird, wenn im Zuge des ersten Umschaltprozesses das Submodul wieder in den on-Schaltungszustand versetzt wird.

Dadurch wird eine verfahrenstechnische Einheit aus einer Sollwertsetzung, einem Soll-Ist-Vergleich und einem Abgleich zwischen der durch das Submodul realisierten Leistung und der in der gesamten Photovoltaikanlage erbrachten Leistung und somit eine Leistungsanpassung zwischen dem Teil der Photovoltaikanlage und dem Submodul erreicht. Erfindungsgemäß wird das Zurücksetzen an einem Schaltzeitpunkt ausgeführt, der von der Größe einer Abweichung zwischen dem Sollwert und der Submodulstromstärke abhängig ist. Durch diese Ausgestaltung wird berücksichtigt, dass kleine Abweichungen zwischen dem Ist- und dem Sollwert des Stromes des Submoduls häufig nur kurzzeitig und vorübergehend auftreten, sodass ein Zurücksetzen des Submoduls in den bypass-Schaltzustand nicht zwingend erforderlich ist. Ein Zurücksetzen unterbleibt dann, wenn die Abweichung bereits vor dem Schaltzeitpunkt wieder verschwunden ist.

Der Schaltzeitpunkt des Zurücksetzens wird bei einer zweckmäßigen Ausführungsform durch ein Entladeverhalten eines dem Submodul zugeschalteten Kondensators beeinflusst. Kleinere Abweichungen führen zu langsamen Entladungen, größere zu rascheren Entladungen des Kondensators und dementsprechend zu späteren bzw. früheren Schaltzeitpunkten.

Bei einer weiteren Ausführungsform ist der Umschaltzeittakt selbst variabel ausgeführt. Insbesondere weist dieser einen von der Submodulstromstärke abhängenden Wert auf. Dabei wächst der Umschaltzeittakt bzw. die Schaltfrequenz oder gleichbedeutend damit die Anzahl der Umschaltimpulse je Zeiteinheit mit abnehmender Submodulstromstärke.

Diese Ausführungsform berücksichtigt zum einen den Umstand, dass ein Submodul, das eine konstant hohe Submodulstromstärke liefert, weniger oft in den bypass-Schaltzustand gesetzt werden muss, als ein Submodul, bei dem die Submodulstromstärke vergleichsweise niedrig ist oder wechselt. Im ersten Fall ist eine Änderung des Schaltzustandes tendentiell nachteilig, weil das konstant arbeitende Submodul abgetrennt werden müsste, im zweiten Fall ist dies vorteilhaft, weil das Submodul relativ rasch wieder nach einem Überbrücken in den Schaltungsverband der Photovoltaikanlage zugeschaltet wird.

Natürlich kann der Umschaltzeittakt extern über eine Schnittstelle beliebig einstellbar gestaltet sein. Dies betrifft insbesondere ein zwangsweises Setzen des Submoduls in den Bypass-Schaltzustand für Wartungs- und Reparaturzwecke oder im Falle von Gefahr oder Brand.

Hierzu kann die Schnittstelle zur Zwangssteuerung mit einer Kommunikationseinheit verbunden ist, die im Gefahr- und/oder Wartungsfall das mindestens eine Submodul in den bypass-Schaltzustand versetzt.

Weiterhin kann als weitere Ausgestaltung vorgesehen sein, dass das mindestens eine Submodul für einen Transport über die Schnittstelle zur Zwangssteuerung in den bypass-Schaltzustand versetzbar ist. Durch diese Transportsicherung wird es ermöglicht, das Submodul in einem definierten Zustand gefahrlos am Montageort zu installieren und in Betrieb zu nehmen.

Erfindungsgemäß ist zur Steuerung der Energieerzeugung in einer Photovoltaikanlage mit mindestens einem in die Photovoltaikanlage geschalteten Submodul eine Steuerschaltung mit einer ersten Strommesseinrichtung zum Messen einer von dem Submodul erzeugten Stromstärke, einer zweiten Strommesseinrichtung zum Messen einer in der Photovoltaikanlage erzeugten Stromstärke, einem Umschalter zum Setzen des Submoduls ein einen on- oder einen bypass-Schaltzustand und eine den Umschalter stellende Timereinheit oder eine andere Führungsgröße vorgesehen. Erfindungsgemäß weist das Submodul einen parallel geschalteten Kondensator auf. Bei einer Ausführungsform weist weiterhin die Timereinheit oder eine den Resetpuls beeinflussende, andere Führungsgröße einen von dem Submodul und/oder der Photovoltaikanlage gespeisten Zeitgeber-Kondensator auf. Dadurch kann der Zeittakt der Timereinheit direkt aus dem Betriebszustand des Submoduls und/oder der Photovoltaikanlage abgeleitet und durch diesen bestimmt werden.

Bei einer Ausführungsform ist als Strommesseinrichtung eine Anordnung von in einem Messshunt angeordneten Schalttransistoren vorgesehen, oder es kann der Bahnwiderstand eines Transistors selbst als Shunt genutzt werden. Zweckmäßigerweise weist die Steuerschaltung eine Schnittstelle zum Ausführen einer Zwangsschaltung des Submoduls in einen on- oder bypass-Schaltzustand auf.

### Zeichnungen

Die Steuerungsvorrichtung und das erfindungsgemäße Verfahren sollen nachfolgend anhand von Ausführungsbeispielen näher erläutert werden. Es ist zu beachten, dass die Zeichnungen nur beschreibenden Charakter haben und nicht dazu gedacht sind, die Erfindung in irgendeiner Form einzuschränken. Es zeigen:
- Fig. 1: eine beispielhafte Darstellung einer Photovoltaikanlage mit Submodulen und einer zugeordneten Steuerschaltung,
- Fig. 2: ein Submodul mit einer Steuerschaltung in einer ersten beispielhaften Ausführungsform,
- Fig. 3: ein Submodul mit einer Steuerschaltung in einer weiteren beispielhaften Ausführungsform,
- Fig. 4: einen beispielhaften Ablaufplan zum Ausführen einer Steuerung der Solarstromerzeugung in einem Submodul,
- Fig. 5: eine Darstellung eines beispielhaften Schaltvorgangs während der Steuerung der Solarstromerzeugung in einem Zeitdiagramm,
- Fig. 6: eine Darstellung eines beispielhaften von einem Grad einer Abschattung abhängigen Schaltverhaltens.

### Ausführungsformen der Erfindung

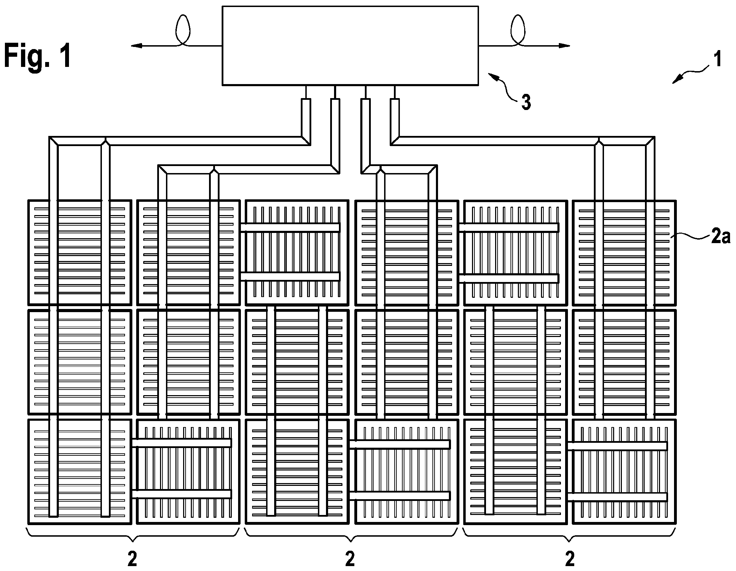

Fig. 1 zeigt eine beispielhafte Photovoltaikanlage **1.** Diese besteht aus einer Reihe von miteinander verschalteten Submodulen **2,** die jeweils aus einzelnen Solarzellen **2a** aufgebaut sind. Die in jeder einzelnen Solarzelle photovoltaisch erzeugte Spannung wird durch die Verschaltung aufaddiert. Im Ergebnis erzeugt somit jedes einzelne Submodul **2** eine Spannung über dem Submodul und trägt schließlich zu einer Gesamtspannung über der gesamten Photovoltaikanlage bei.

Die einzelnen Submodule fungieren bei diesem Aufbau als kleinste funktionelle Einheit und werden von einer Steuerschaltung **3** angesteuert. Die Steuerschaltung überwacht die Stromstärke des von jedem einzelnen Solarmodul erzeugten elektrischen Solarstromes. Sobald in einem oder mehreren Submodulen die Stromstärke des Solarstromes insbesondere infolge einer Abschattung unter einen bestimmten Wert fällt, werden die entsprechenden Submodule durch die Steuerschaltung überbrückt, sodass sich deren innerer Widerstand nicht negativ auf die gesamte Photovoltaikanlage auswirkt.

Im Folgenden wird die Wirkungsweise der Steuerschaltung anhand einer Anordnung aus einem Submodul und einer Steuerschaltung für dieses Submodul erläutert. Bei Photovoltaikanlagen, die aus mehreren Submodulen aufgebaut sind, ist entweder jedem einzelnen Submodul eine eigene Steuerschaltung zugeordnet oder es können je nach Zweckmäßigkeit auch mehrere Submodule mit einer Steuerschaltung verknüpft sein.

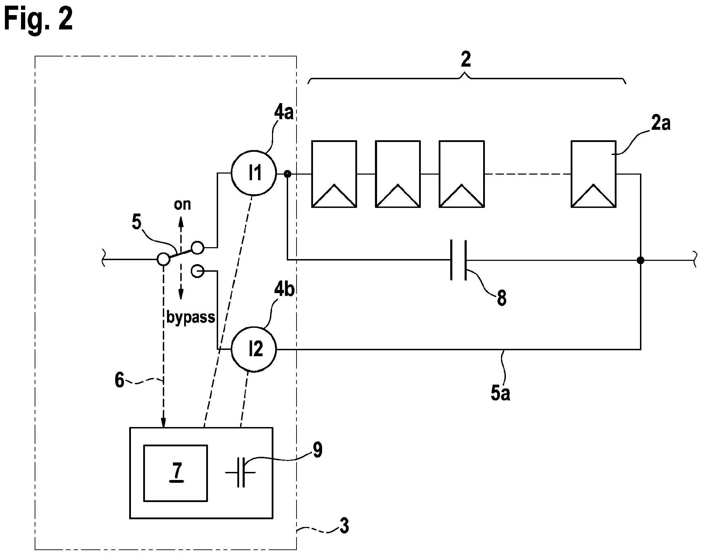

Fig. 2 zeigt eine beispielhafte Darstellung eines Schaltplans eines Submoduls **2** mit einer Steuerschaltung **3** in einer ersten beispielhaften Ausführungsform. Das hier dargestellte Submodul besteht aus einer Anordnung aus mehreren einzelnen Solarzellen **2a.** Die Steuerschaltung enthält eine Strommesseinrichtung **4** mit Strommessern **4a** und **4b,** einen Umschalter **5,** der von einem Umschaltimpuls **6** beaufschlagt wird, sowie eine Timereinheit **7.**

Der Umschalter **5** dient zum Ein- und Auskoppeln des Submoduls. Dieser kann entweder einen on-Schaltzustand oder einen bypass-Schaltzustand einnehmen. Bei dem on-Schaltzustand ist das Submodul in das Gesamtsystem der Photovoltaikanlage geschaltet. Der Systemstromfluss innerhalb der Photovoltaikeinrichtung durchläuft dabei die Solarzellen **2a** des Submoduls, die ihren Teil des Solarstroms beitragen. Bei dem bypass-Schaltzustand wird das Submodul überbrückt und ist somit aus der Verschaltung der Photovoltaikanlage ausgekoppelt. Der Gesamtstromfluss wird in einem solchen Fall über einen das Submodul überbrückenden Strompfad **5a** geleitet.

Der durch diese Anordnung erzeugte bzw. fließende Solarstrom wird von der Strommesseinrichtung **4** erfasst. Dabei misst der erste Strommesser **4a** während des on-Schaltungszustandes eine durch das Submodul ermöglichte Stromstärke **I1** und der zweite Strommesser **4b** während des bypass-Schaltungszustandes eine innerhalb der gesamten Photovoltaikanlage ermöglichte Stromstärke **12.** Beide Werte werden in einer hier nicht gezeigten Sample-and-Hold-Schaltung miteinander verglichen.

Die Timereinheit **7** beaufschlagt den Umschalter **5** mit einem Umschaltimpuls **6.** In einem solchen Fall wechselt der Schaltzustand des Umschalters **5** von dem on- in den bypass-Schaltzustand oder von dem bypass-Schaltzustand zurück in den on-Schaltzustand. Das Submodul ist dadurch entweder überbrückt und aus dem Gesamtsystem der Photovoltaikanlage abgekoppelt oder in die Schaltung der Photovoltaikanlage integriert.

Dieser Schaltvorgang wird durch einen Kondensator **8** beeinflusst. Dieser ist parallel zu dem Submodul **2** geschaltet und lädt sich während des Betriebs des Submoduls auf. Bei einer Abschattung des Submoduls findet eine Entladung des Kondensators **8** statt. Die an dem Strommesser **4a** registrierte Stromstärke **I1** sinkt dadurch mit einer durch den Entladestrom des Kondensators bedingten Zeitkonstante ab, sodass die Stromstärke **I1** nach einer gewissen Verzögerung unter einen vorgegebenen Schwellwert fällt. Der Kondensator **8** bewirkt somit ein verzögertes Umschalten des Umschalters **5** von dem on- in den bypass-Schaltzustand.

Wichtig ist hierbei, dass die Verzögerung dieses Umschaltvorgangs von dem Ladezustand des Kondensators und von der Leistung des Submoduls **2** abhängt. Bei einer nur kurzzeitigen oder schwachen Abschattung des Submoduls **2** gibt der Kondensator **8** einen Entladestrom mit einer relativ großen Zeitkonstante ab, sodass die Stromstärke **I1** erst nach einer verhältnismäßig langen Zeitdauer unter den gegebenen Schwellwert fällt. In einem solchen Fall setzt das Umschalten in den bypass-Schaltzustand mit einer großen Verzögerung ein oder kann auch unterbleiben. Dadurch wird das nur schwach abgeschattete Submodul nicht aus der Gesamtschaltung ausgekoppelt, wobei der Kondensator als vorübergehender Energiespeicher wirkt.

Bei einer starken Abschattung, insbesondere einer vollkommenen Verdunkelung des Submoduls, findet die Entladung des Kondensators mit einer relativ kleinen Zeitkonstante statt. Der Kondensator entlädt sich schnell, die Stromstärke **I1** sinkt damit entsprechend schnell unter einen vorgegebenen Schwellwert und das Umschalten in den bypass-Schaltzustand erfolgt somit nach einem vergleichsweise kurzen Zeitintervall. Dadurch wird das vollkommen verdunkelte und für die Energieerzeugung nunmehr nutzlose Submodul rasch überbrückt.

Ein Zurückschalten in den on-Schaltzustand erfolgt durch einen erneuten Umschaltimpuls der Timereinheit.

Hierzu weist die Timereinheit eine Zeittaktung auf, die nach dem Umschalten in den bypass-Schaltzustand ein periodisches Umschalten des Umschalters in den on-Schaltzustand bewirkt. In dem in Fig. 2 gezeigten Ausführungsbeispiel ist hierzu ein Zeitgeber-Kondensator **9** vorgesehen. Dieser triggert durch seine Entladung das Auslösen eines erneuten Umschaltimpulses und somit einen alternierenden Wechsel des Umschalters **5** zwischen dem on- und dem bypass-Schaltzustand.

Sofern der Zeitgeber-Kondensator durch das Submodul oder die Photovoltaikanlage gespeist ist, ist dessen Triggerfunktion direkt mit der aktuellen Energieerzeugung des Submoduls oder der Photovoltaikanlage gekoppelt. Damit kann nach einer durch aus dem Solarstrom der Photovoltaikanlage oder des Submoduls abgeleiteten Zeit der Umschalter in die jeweils andere Position umgeschaltet werden.

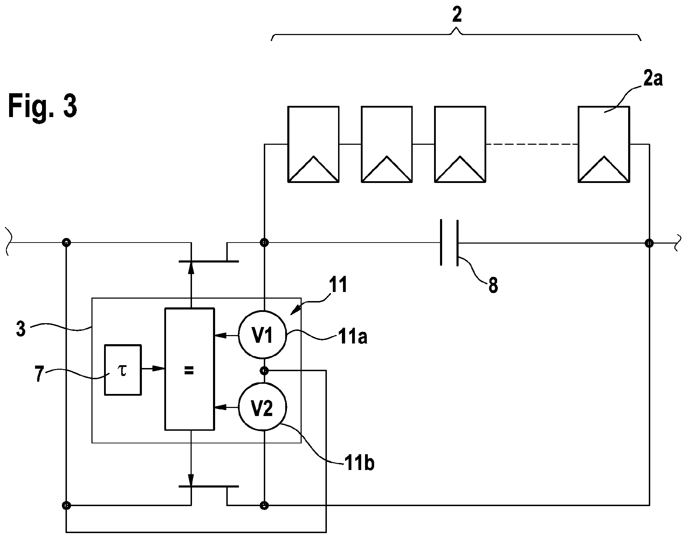

Fig. 3 zeigt ein Submodul mit einer Steuerschaltung **3** in einer weiteren beispielhaften Ausführungsform. In dem hier vorliegenden Beispiel ist die Steuerschaltung monolithisch und integriert ausgeführt. Die Steuerschaltung weist hierzu eine integrierte Timereinheit **7** auf. Zur Messung der Stromstärken **I1** und **12** sind im hier vorliegenden Beispiel zwei Schalttransistoren vorgesehen. Der bei jedem Schalttransistor gegebene Durchlasswiderstand zwischen Drain und Source dient hierbei als Messshunt **11** für die Schaltlogik. Der Messshunt besteht aus zwei Shunts **11a** und **11b.** Die über den ohmschen Widerständen der Shunts jeweils abfallenden Spannungen **V1** und **V2** werden in den jeweiligen on- bzw. bypass-Schaltzuständen abgefragt und in die Stromstärkewerte **I1** und **12** umgerechnet. Dabei gibt der Timer den intern vorgegebenen Umschaltzeitpunkt und damit die Zeittaktung zur erneuten Messung vor. Auch bei dem hier vorliegenden Beispiel ist das Submodul durch den Kondensator **8** abgepuffert, sodass in der beschriebenen Weise ein Übergang des Submoduls in den überbrückten Zustand zu dem von der Entladung des Kondensators bestimmten verzögerten Zeitpunkt erfolgt.

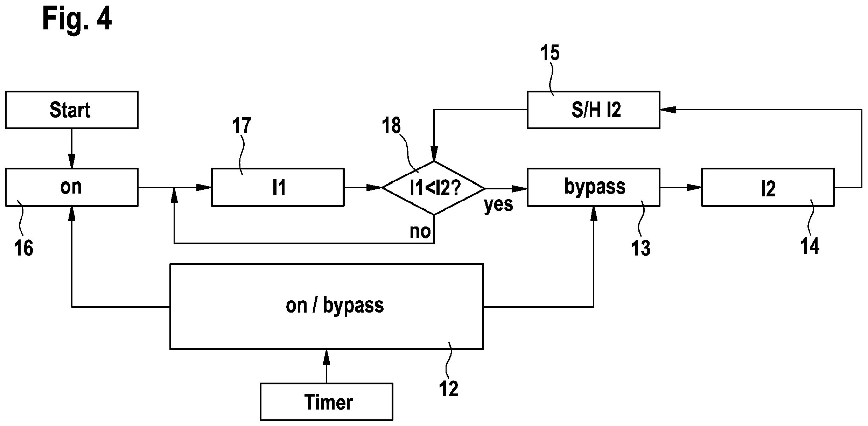

Fig. 4 zeigt einen beispielhaften Ablaufplan der Steuerung der Solarstromerzeugung. Dieser enthält zwei ineinander greifende schleifenförmig ausgeführte Verfahrensabläufe.

Ein erster Verfahrensablauf betrifft eine kontinuierliche Sollwertaktualisierung in der Photovoltaikanlage. Dieser beginnt mit einem Reset-Schritt **12,** bei dem ein Umschaltsignal an den Umschalter ausgegeben wird. Der Umschalter wird daraufhin in einem Schaltschritt **13** in den bypass-Schaltzustand geschaltet. Als nächstes wird der Wert für den Systemstrom **12** in einem Schritt **14** gemessen und in einer Sample-and-Hold (S/H) Stufe der Steuerschaltung in einem Schritt **15** gespeichert. Die Sample- and Hold-Stufe kann in Form eines internen Speichers oder z. B. als analoge Spannung über eine integrierte Kapazität ausgebildet sein.

Ein zweiter Verfahrensablauf wird durch eine kontinuierliche Messung der von dem Submodul erzeugten Stromstärke **I1** und einen fortlaufenden Vergleich des dabei bestimmten Wertes mit dem in der Sample-and-Hold-Stufe gespeicherten Wert für den Systemstrom **12** gebildet. Hierzu erfolgt ein Schaltvorgang **16,** bei dem der Umschalter auf den on-Schaltzustand umgeschaltet wird. Danach wird in einem Messschritt **17** die von dem Submodul erzeugte Stromstärke **I1** gemessen. Gleichzeitig wird geprüft, ob die Stromstärke **I1** unter einen durch den Wert **12** oder einen entsprechend daran orientierten Schwellwert gefallen ist.

Die Timereinheit erzeugt dabei in einem festen Umschalttakt **T** ein alternierendes Schalten zwischen dem on- und dem bypass-Schaltzustand, sodass die beiden genannten Verfahrensabläufe alternierend ausgeführt werden. Dieses alternierende Schalten ist zweckmäßigerweise so gestaltet, dass ein Set-Puls den Umschalter in die bypass-Schaltstellung schaltet und ein nachfolgender Reset-Puls den Umschalter wieder in die on-Schaltstellung setzt, sodass sich nach dem Reset-Puls der Umschalter stets in der on-Schaltstellung befindet.

Dabei kann der on-Schaltzustand jederzeit durchbrochen werden. Dies ist dann der Fall, sobald ein mit dem Messschritt **17** verknüpfter Entscheidungsschritt **18** signalisiert, dass die Stromstärke **I1** unter den durch den Wert **12** gesetzten oder einen an dem Wert **12** orientierten Sollwert abfällt. Dabei wird der Umschalter in den bypass-Schaltzustand durch ein erneutes Ausführen des Schrittes **13** geschaltet und das Submodul aus dem Stromkreis getrennt. Das Submodul arbeitet dann autark und lädt den Kondensator **8** durch die im Submodul weiterhin erzeugte Solarenergie wieder auf.

Dieser bypass-Schaltzustand wird spätestens dann wieder beendet, wenn die Timereinheit einen erneuten Umschaltimpuls an den Umschalter ausgibt, so dass der Resetschritt **12** und im Gefolge damit die Verfahrensschritte **16, 17** und **18** erneut durchlaufen werden.

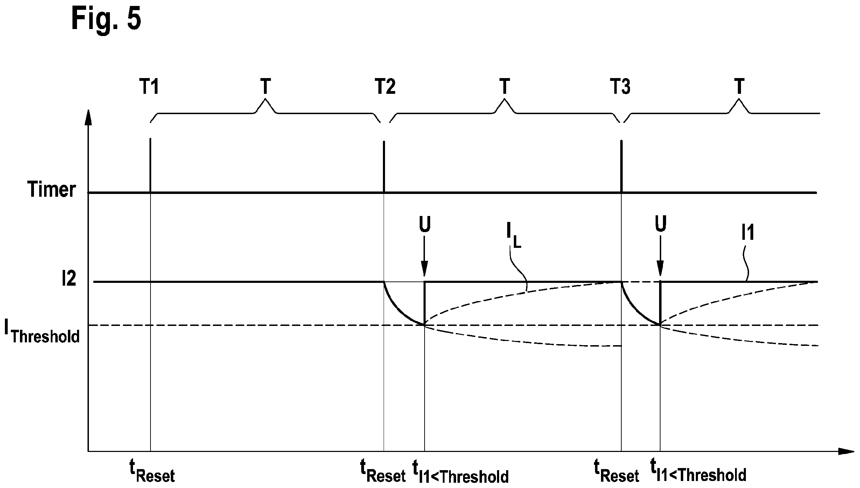

Fig. 5 zeigt eine Darstellung eines beispielhaften Schaltvorgangs während der Steuerung der Solarstromerzeugung anhand eines Zeitdiagramms. Das Diagramm enthält zum einen eine Darstellung der durch die Timereinheit **7** ausgegebenen Folge von Umschaltimpulsen **T1, T2** und **T3.** Diese folgen innerhalb eines Umschalttaktes **T** aufeinander. Darunter ist der zeitliche Verlauf der Stromstärke **I1** dargestellt.

Während des ersten Umschaltimpulses **T1** entspricht der Strom **I1** dem Systemstrom **12.** Zum Zeitpunkt **T2** des zweiten Reset-Impulses tritt eine Verschattung ein, die den Strom des Submoduls auf beispielsweise 70 % des Systemstroms reduziert. Dabei unterschreitet der Strom **I1** zu einem Zeitpunkt t_{I1}<Threshold einen hier angegebenen Schwellwert I_{Threshold} von beispielsweise 80 % des Stromes **12.** Dieses Unterschreiten löst einen Umschaltimpuls **U** aus. Ab diesem Zeitpunkt ist das Submodul gebrückt. Die weiterhin im Submodul ablaufende Solarstromerzeugung lädt den Kondensator **8** wieder entlang gestrichelten Linie **I_{L}** auf. Zum Zeitpunkt des dritten Reset-Impulses **T3** wird der Umschalter wieder auf den on-Schaltzustand gesetzt und der Kondensator entlädt sich erneut. Da im hier vorliegenden Fall die Verdunkelung des Submoduls noch nicht wieder überwunden ist, wird ein erneuter Umschaltimpuls **U** ausgelöst und der beschriebene Vorgang wiederholt sich. Dabei wird in dem überbrückten Submodul fortlaufend Strom erzeugt, in dem Kondensator gesammelt und nach den Zeitpunkten **T1** und **T2** an das System abgegeben.

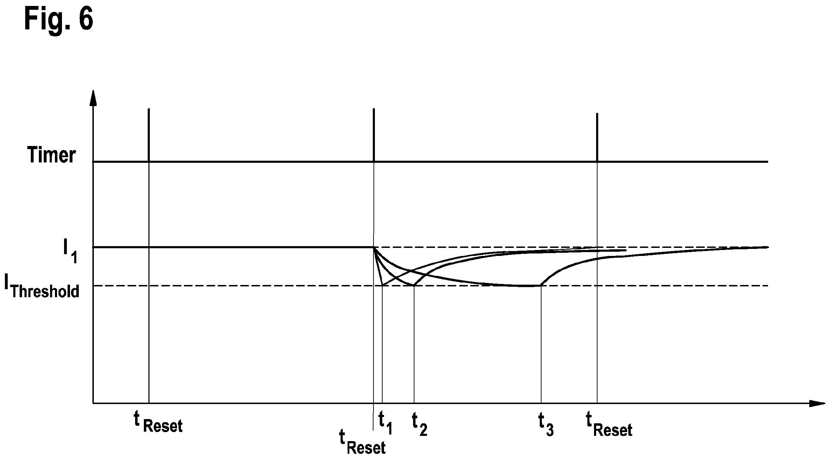

Fig. 6 zeigt anhand eines Diagramms eine Darstellung eines beispielhaften von einem Grad einer Abschattung abhängigen Schaltverhaltens. Liegt die durch das Submodul erzeugte Solarenergie deutlich unter der des Gesamtsystems, was bei einer starken Verschattung der Fall ist, fällt der Submodul-Strom **I1** sehr schnell unter den durch den Systemstrom **12** definierten Wert I_{Threshold} und der Umschalter schaltet bereits zum Zeitpunkt t₁ auf den bypass-Schaltzustand. Liegt dagegen eine nur schwache Verschattung vor, entlädt sich der Kondensator wegen des höheren Endwertes deutlich langsamer, so dass der Schalter deutlich später zu einem Zeitpunkt t₂ oder t₃ auf den bypass-Schaltzustand umschaltet. Das Submodul leistet dadurch einen erheblichen Beitrag zur Gesamtenergiegewinnung.

Die Zeitsteuerung der Timereinheit, d. h. der Zeittakt **T,** kann aber auch variiert und mit dem Betrieb des Submoduls rückgekoppelt sein. Dabei wird der zunächst feste Zeittakt T variiert, sodass die Reset-Impulse rascher oder langsamer aufeinander folgen. Diese Zeitsteuerung wird vorteilhafterweise durch das Submodul selbst vorgegeben und ist so eingestellt, dass diese mit zunehmender Verschattung d. h. in Abhängigkeit vom Abfall des Stroms **I1,** sich zu kürzeren Zeiten verschiebt.

Diese Ausgestaltung bietet den Vorteil, dass die im Gesamtsystem in Reihe geschalteten Submodule mit den jeweils zugeordneten Schaltvorrichtungen sich nicht gegenseitig über mehr als einen Schaltzyklus beeinflussen. Das heißt, dass die Wahrscheinlichkeit, dass zwei oder mehrere Schaltvorrichtungen zeitgleich in den bypass-Schaltzustand übergehen und damit theoretisch im Extremfall sämtliche Submodule überbrückt werden könnten, zu vernachlässigen ist.

Ein weiterer Vorteil besteht darin, dass bei geringerer Sonneneinstrahlung auch die Zellkapazität im Sinne eines inhärenten Kondensators des Submoduls geringer wird und damit bei kürzer werdenden Solarströmen die Kondensatoren schneller entladen und auch wieder aufgeladen sein können.

Eine weitere Ausgestaltung besteht in der Nutzung der inhärenten Kapazität der Solarzellen **2a.** Diese auch als Diodenkapazität bekannte Kapazität des pn-Übergangs ist beleuchtungsabhängig und kann bei Hochleistungssolarzellen von 240 cm² Fläche Werte von bis zu 10 µF im unbeleuchteten Fall und 1000 µF bei voller Beleuchtung (1000 W/m²) erreichen. Da diese Kapazität jeweils der die Solarzelle darstellende Stromquelle parallel geschaltet ist, kann näherungsweise die Gesamtkapazität des Substrings in der gleichen Größenordnung angesetzt werden. Damit kann in einer vorteilhaften Ausführungsform auf einen separaten externen Kondensator wie beispielsweise in Fig. 2 dargestellt, verzichtet werden.

Für die Optimierung des Wirkungsgrades gilt grundsätzlich, dass der UmschaltImpuls und damit das Messen des jeweils anderen Vergleichstroms nur eine extrem kurze Zeit in Anspruch genommen werden darf. Das ist offensichtlich, da im Fall des unverschatteten Submoduls die zum Vergleich notwendige Messung (und damit Kurzschluss des Submoduls) den erzielbaren Ertrag schmälert. Geht man aber von einer Messzeit von 100 µs für diese Umschaltung aus (bei extrem hoch angesetzter Kondensatorgröße von 1000 µF bei Volleinstrahlung und R_{DSon} von 100 mOhm) und einer Hold-Zeit (Zeit bis zum nächsten Reset) von 1 s bei Volleinstrahlung, erhält man einen Effizienzverlust von 100 ppm oder 0,01 %. Dazu muss aber der Verlust über den in Fig. 3 gezeigten Messshunt hinzugerechnet werden. Bei einem Nennstrom von 8 A fallen damit 800 mW über einem Energieschalter ab - bei einer Ausstattung von drei Energieschaltern pro Modul mit 240W Nennleistung ergibt sich daher ein Leistungsverlust von 3 x 24 mW = 72 mW durch den Rücksetzimpuls und 3 x 800mW = 2,4 W durch die in Serie geschalteten Leistungstransistoren - in Summe also etwa 3W pro Solarmodul.

Bei geringerer Sonneneinstrahlung verringern sich die Zellkapazitäten um etwa den Faktor 100, so dass etwa 10 µF Zellkapazität bei einer 156 mm-Solarzelle zu erwarten wäre. Damit verringert sich die Messzeit auf 1 µs. Aufgrund der dann aber sinnvollerweise kürzeren Reset-Intervalle verschiebt sich der Effizienzverlust ebenfalls. Sinnvolle Annahmen könnten hier bei 1 ms liegen, so dass im unverschatteten Betrieb immer noch eine Effizienz von 99,9 % erreicht werden könnte abzüglich der proportional kleineren Verluste durch die Leistungstransistoren von wiederum etwa 1 %.

Näherungsweise verliert man durch den Einsatz der hier beschriebenen Vorrichtung sowie der Ausführung des Verfahrens also etwa 1 % des Solarstroms im unverschatteten Zustand. Dem steht aber ein proportionaler Zugewinn im Verschattungsfall gegenüber. Der dazu notwendige schaltungstechnische Aufwand liegt deutlich unter dem bekannter modulbasierter MPP-Tracker mit integriertem DC/DC-Wandler.

Zur Leistungsabschätzung kann beispielsweise ein Leistungstransistor (FET) angenommen werden, der bei einem maximalen Durchschaltstrom von 16 A und einer maximalen Schaltspannung von 16 A einen ohmschen Widerstand zwischen Drain und Source R_{DSon} von 100 mOhm hat. Eine Optimierung dieses Einschaltwiderstands z. B. auf 10mOhm reduziert den Leistungsverlust auf im Beispiel knapp 0,32 Watt und damit deutlich unter 0,2 %. Mit anderen Worten: das hier gezeigte Verfahren sichert einen Wirkungsgrad von 99,8 % im Vergleich zur Leistung eines unverschatteten Submoduls. Dieser geringen Einbuße des Wirkungsgrades steht jedoch eine effektive Leistungsaubeute des Submoduls im Verschattungsfall gegenüber.

Über den Einsatz einer Kommunikationsschnittstelle, die den Umschalter zwangsweise in die bypass-Schaltstellung überführt, kann das Submodul und folgend die gesamte Photovoltaikanlage stromlos und sogar in den Kurzschluss des Moduls geschalten werden. Eine derartige Schaltstellung wird nachfolgend als "disabled" bezeichnet. Das kann sinnvoll sein, wenn z. B. während eines notwendig gewordenen Modultausches das Submoduls tagsüber aufgetrennt werden muss oder z. B. im Brandfall die Anlage stromlos geschaltet werden muss, um z. B. ein Dach zur Brandbekämpfung zu öffnen.
Ein möglicher Ansatz der Kommunikation kann dabei eine separate Steuerleitung sein, die an sämtlichen Submodulen angeschlossen wird. Ebenso könnten Powerline-Konzepte genutzt werden, bei denen Signale über die Solarstromleitungen geschickt werden oder drahtlose Ansätze über bekannte Hochfrequenzkommunikationsprotokolle (Zigbee, W-LAN, etc). Werden Powerline-Konzepte genutzt, kann z.B. das Anliegen eines "Enable"-Signals zwingend für die normale in Fig. 3 gezeigte Betriebsart des Moduls notwendig sein. Dabei ist eine intakte Solarstromleitung für die Übertragung dieses Enable-Signals erforderlich. Entsteht im Fehlerfall ein Lichtbogen, stören die dabei auftretenden Störspektren dieses Enable-Signal derart, dass der Kommunikationsbaustein dieses Signal nicht mehr erkennt und in den "disable"-Modus schaltet. Damit wäre auch eine Lichtbogenerkennung und automatische Auslöschung durch Herunterschalten der Spannung im Stromkreis (durch "herausschalten" der Submodule) bis zum Verlöschen des Lichtbogens gegeben.

Im Rahmen fachmännischen Handelns ergeben sich weitere Ausgestaltungen und Ausführungsformen des hier nur beispielhaft beschriebenen Verfahrens und der Vorrichtung. Weitere Ausführungsformen ergeben sich aus den Unteransprüchen.

## Patentansprüche

1. Verfahren zur Steuerung einer Stromerzeugung in einer Photovoltaikanlage mit mindestens einem in die Photovoltaikanlage geschalteten Submodul,
umfassend
einen ersten Umschaltprozess, während dessen ein in einem Umschaltzeittakt (T) alternierendes Schalten des Submoduls zwischen einem on-Schaltzustand und einem bypass-Schaltzustand erfolgt, wobei das Submodul bei dem on-Schaltzustand der Photovoltaikanlage verschaltet ist und in dem bypass-Schaltzustand überbrückt ist,
wobei
während des bypass-Schaltzustandes eine Gesamtstromstärke (I2) der Photovoltaikanlage gemessen und ein daraus ermittelter Sollwert (I_{Threshold}) zwischengespeichert wird und während des on-Schaltzustandes eine Submodulstromstärke (I1) gemessen und mit dem Sollwert verglichen wird,
**dadurch gekennzeichnet, dass**
bei einem Absinken der Submodulstromstärke (I1) unter den Sollwert ein zweiter Umschaltprozess, nämlich ein von dem Umschaltzeittakt (T) unabhängig erfolgendes Zurücksetzen (Z) des Submoduls in den bypass-Schaltzustand ausgeführt wird, wobei der Umschaltzeittakt (T) einen von der Submodulstromstärke (I1) abhängigen Wert aufweist.

2. Verfahren nach Anspruch 1,
**dadurch gekennzeichnet, dass**
das Zurücksetzen (Z) an einem Schaltzeitpunkt (t1, t2, t3) ausgeführt wird, der von der Größe einer Abweichung (ΔI) zwischen dem Sollwert (I_{Threshold}) und der Submodulstromstärke (I1) abhängig ist.

3. Verfahren nach Anspruch 1 oder 2,
**dadurch gekennzeichnet, dass**
der Schaltzeitpunkt (t1, t2, t3) des Zurücksetzens (Z) durch ein Entladeverhalten eines dem Submodul zugeschalteten Kondensators beeinflusst wird.

4. Verfahren nach einem der vorhergehenden Ansprüche,
**dadurch gekennzeichnet, dass**
der Schaltzeitpunkt (t1, t2, t3) des Zurücksetzens (Z) durch ein Entlade-verhalten mindestens einer inhärenten beleuchtungsabhängigen Kapazität einer Solarzelle des Submoduls beeinflusst wird.

5. Verfahren nach einem der vorhergehenden Ansprüche,
**dadurch gekennzeichnet, dass**
der Umschaltzeittakt (T) extern über eine Schnittstelle beliebig einstellbar ist.

6. Vorrichtung zur Steuerung der Energieerzeugung in einer Photovoltaikanlage mit mindestens einem in die Photovoltaikanlage geschalteten Submodul, enthaltend eine Steuerschaltung (3) mit einer ersten Strommesseinrichtung (4a) zum Messen einer von dem Submodul (2) erzeugten Stromstärke, einer zweiten Strommesseinrichtung (4b) zum Messen einer in der Photovoltaikanlage erzeugten Stromstärke, einen Umschalter (5) zum Setzen des Submoduls in einen on- oder einen bypass-Schaltzustand und eine den Umschalter stellende Timereinheit (7),
**dadurch gekennzeichnet, dass**
die Timereinheit (7) einen von dem Submodul und/oder der Photovoltaikanlage gespeisten Zeitgeber-Kondensator (9) aufweist, sodass dessen Triggerfunktion direkt mit der aktuellen Energieerzeugung des Submoduls oder der Photovoltaikanlage gekoppelt ist.

7. Vorrichtung nach Anspruch 6,
**dadurch gekennzeichnet, dass**
das Submodul (2) einen Energiespeicher in Form eines parallel geschalteten Kondensators (8) aufweist.

8. Vorrichtung nach Anspruch 6 oder 7,
**dadurch gekennzeichnet, dass**
das Submodul einen Energiespeicher in Form einer inhärenten Diodenkapazität der Solarzellen (2a) aufweist.

9. Vorrichtung nach einem der Ansprüche 6 bis 8,
**dadurch gekennzeichnet, dass**
als Strommesseinrichtung (4a, 4b) eine Anordnung von in einem Messshunt (11) angeordneten Schalttransistoren (11a, 11 b) vorgesehen ist.

10. Vorrichtung nach einem der Ansprüche 6 bis 9,
**dadurch gekennzeichnet, dass**
die Steuerschaltung eine Schnittstelle zum Ausführen einer Zwangsschaltung des Submoduls in einen on- oder bypass-Schaltzustand aufweist.

11. Vorrichtung nach einem der Ansprüche 6 bis 9,
**dadurch gekennzeichnet, dass**
die Schnittstelle zur Zwangssteuerung mit einer Kommunikationseinheit verbunden ist, die im Gefahr- und/oder Wartungsfall das mindestens eine Submodul in den bypass-Schaltzustand versetzt.

12. Vorrichtung nach einem der Ansprüche 6 bis 9,
**dadurch gekennzeichnet, dass**
für einen Transport das mindestens eine Submodul über die Schnittstelle zur Zwangssteuerung in den bypass-Schaltzustand versetzbar ist.

## Claims

1. A method for controlling power generation in a photovoltaic system with at least one submodule connected to the photovoltaic system, comprising
a first switching process during which an alternating toggling of the submodule between a on state and a bypass state is performed with a switching cycle (T), wherein in the on state the submodule is connected to the photovoltaic system and bypassed in the bypass state, wherein
during the bypass state an overall current (I2) of the photovoltaic system is measured and a target value (I_{Threshold}) derived therefrom is intermediately stored, and during the on state a submodule current (I1) is measured and compared with the target value, **characterized in that**
in case the submodule current (I1) falls below the target value, a second switching process is performed, that is a resetting (Z) of the submodule into the bypass state independent of the switch cycle (T).

2. The method of claim 1,
**characterized in that**
the resetting is performed at a switching point (t1, t2, t3) depending on the extent of a deviation (ΔI) between the target value (I_{Threshold}) and the submodule current (I1).

3. The method of claim 1 or 2,
**characterized in that**
the switching point (t1, t2, t3) of the resetting (Z) is influenced by a discharging behavior of a capacitor connected to the submodule.

4. The method of any of the preceding claims,
**characterized in that**
the switching point (t1, t2, t3) of the resetting (Z) is influenced by a discharging behavior of at least one inherent, insolation-dependent capacitance of a solar cell of the submodule.

5. The method of any of the preceding claims,
**characterized in that**
the switching cycle (T) is externally freely adjustable via an interface.

6. A device for controlling power generation in a photovoltaic system with at least one submodule connected to the photovoltaic system, comprising
a control circuit (3) with a first current measurement device (4a) for measuring a current generated by the submodule (2), a second current measurement device (4b) for measuring a current generated in the photovoltaic system, a changeover switch (5) for setting the submodule into an on state or a bypass state and a timer unit (7) controlling the changeover switch
**characterized in that**
the timer unit (7) comprises a timer capacitor (9) energised by the submodule and/or the photovoltaic system, such that a trigger function thereof is directly coupled to the current power generation of the submodule or the photovoltaic system.

7. The device of claim 6,
**characterized in that**
the submodule (2) comprises a parallel connected capacitor (8) as an energy store.

8. The device of claim 6 or 7,
**characterized in that**
the submodule comprises a inherent diode capacitance of the solar cells (2a) as an energy store.

9. The device of any of the claims 6 to 8,
**characterized in that**
an arrangement of switching transistors (11 a, 11 b) arranged in a measurement shunt (11) is provided as current measurement device (4a, 4b).

10. The device of any of the claims 6 to 9,
**characterized in that**
the control circuit comprises an interface for performing a forced transition of the submodule into an on or bypass state.

11. The device of any of the claims 6 to 9,
**characterized in that**
the interface is connected to a communication unit for forced control that switches the at least one submodule into the bypass state in case of danger and/or maintenance.

12. The device of any of the claims 6 to 9,
**characterized in that**
for transportation the at least one submodule can be set into the bypass state via the interface for forced control.

## Revendications

1. Procédé destiné à commander une génération de courant dans une installation photovoltaïque avec au moins un sous-module connecté dans l'installation photovoltaïque, comprenant un premier processus de commutation, pendant lequel il s'effectue une commutation alternée du sous-module, à un rythme de commutation (T) entre une position de commutation on et une position de commutation en dérivation, dans la position de commutation on, le sous-module de l'installation photovoltaïque étant interconnecté et étant shunté dans la position de commutation en dérivation,
- dans la position de commutation en dérivation, une intensité de courant totale (12) de l'installation photovoltaïque étant mesurée et une valeur de consigne (I_{Threshold}) déterminée suite à cela étant mise en mémoire-tampon et dans la position de commutation on, une intensité de courant du sous-module (I1) étant mesurée et comparée avec la valeur de consigne,
**caractérisé en ce que**
- lors d'une baisse de l'intensité de courant du sous-module (I1) en-dessous de la valeur de consigne, un deuxième processus de commutation, à savoir une réinitialisation (Z) du sous-module s'effectuant indépendamment du rythme de commutation (T) dans la position de commutation en dérivation est réalisé,
- le rythme de commutation (T) présentant une valeur dépendant de l'intensité de courant du sous-module (I1).

2. Procédé selon la revendication 1,
**caractérisé en ce que** la réinitialisation (Z) est réalisée à un moment de commutation (t1, t2, t3) qui dépend de la grandeur d'un écart (ΔI) entre la valeur de consigne (I_{Threshold}) et l' intensité de courant du sous-module (I1).

3. Procédé selon la revendication 1 ou la revendication 2,
**caractérisé en ce que** le moment de commutation (t1, t2, t3) de la réinitialisation (Z) est influencé par une attitude de décharge d'un condensateur mis en circuit avec le sous-module.

4. Procédé selon l'une quelconque des revendications précédentes,
**caractérisé en ce que** le moment de commutation (t1, t2, t3) de la réinitialisation (Z) est influencé par une attitude de décharge d'au moins une capacité inhérente dépendant de l'éclairage d'une cellule solaire du sous-module.

5. Procédé selon l'une quelconque des revendications précédentes,
**caractérisé en ce que** le rythme de commutation (T) est réglable à volonté en externe, par l'intermédiaire d'une interface.

6. Dispositif destiné à commander la génération d'énergie dans une installation photovoltaïque, avec au moins un sous-module connecté dans l'installation photovoltaïque, contenant un circuit de commande (3) avec un premier système de mesure (4a) du courant, destiné à mesurer une intensité de courant générée par le sous-module (2), un deuxième système de mesure (4b) du courant, destiné à mesurer une intensité de courant générée dans l'installation photovoltaïque, un inverseur (5) destiné à placer le sous-module dans une position de commutation on ou en dérivation et une unité de minuterie (7) réglant l'inverseur,
**caractérisé en ce que**
l'unité de minuterie (7) comporte un condensateur d'horloge (9) alimenté par le sous-module et/ou par l'installation photovoltaïque, de sorte que sa fonction de déclencheur est directement couplée avec la génération d'énergie actuelle du sous-module ou de l'installation photovoltaïque.

7. Dispositif selon la revendication 6,
**caractérisé en ce que** le sous-module (2) comporte un accumulateur d'énergie sous la forme d'un condensateur (8) monté en parallèle.

8. Dispositif selon la revendication 6 ou la revendication 7,
**caractérisé en ce que** le sous-module comporte un accumulateur d'énergie sous la forme d'une capacité inhérente des diodes des cellules solaires (2a).

9. Dispositif selon l'une quelconque des revendications 6 à 8,
**caractérisé en ce qu'**en tant que système de mesure (4a, 4b) du courant, il est prévu un agencement de transistors de commutation (11a, 11b) placés dans un shunt de mesure (11).

10. Dispositif selon l'une quelconque des revendications 6 à 9,
**caractérisé en ce que** le circuit de commande comporte une interface destinée à réaliser une commutation forcée du sous-module dans une position de commutation on ou en dérivation.

11. Dispositif selon l'une quelconque des revendications 6 à 9,
**caractérisé en ce que** l'interface destinée à la commande forcée est reliée avec une unité de communication qui en cas de risque et/ou de maintenance amène l'au moins un sous-module dans la position de commutation de dérivation.

12. Dispositif selon l'une quelconque des revendications 6 à 9,
**caractérisé en ce que** pour un transport, l'au moins un sous-module peut être amené dans la position de commutation de dérivation par l'intermédiaire de l'interface destinée à la commande forcée.
